# NEW EUROPEAN PATENT SPECIFICATION

(11) **EP 0 191 554 B2**
(45) Date of publication and mention of the opposition decision: **06.07.1994**
(45) Mention of the grant of the patent: 05.06.1991
(21) Application number: 86300331.5
(22) Date of filing: 17.01.1986
(51) Int. Cl.: C23C 28/04, C23C 16/30

(54) **Coated cemented carbides and manufacture thereof**
Beschichtetes Sinterkarbid und Verfahren zu seiner Herstellung
Corps de carbures revêtus et son procédé de préparation

(30) Priority: 21.01.1985 JP 9754/85
(43) Date of publication of application: 20.08.1986
(73) Proprietor: SUMITOMO ELECTRIC INDUSTRIES LIMITED, Osaka-shi, Osaka 541 (JP)
(72) Inventor: Tsukada, Hiroshi Itami Works, Itami-shi Hyogo (JP); Tobioka, Masaaki Itami Works, Itami-shi Hyogo (JP); Nomura, Toshio Itami Works, Itami-shi Hyogo (JP); Saito, Yasuhiro Itami Works, Itami-shi Hyogo (JP)
(74) Representative: Cross, Rupert Edward Blount

(56) References cited:
- DE-A- 2 901 871
- DE-B- 1 954 366
- FR-A- 2 415 668
- GB-A- 762 931
- GB-A- 1 601 224
- JP-A- 605 883
- JP-A- 5 299 532
- US-A- 4 162 338
- US-A- 4 341 843
- US-A- 4 497 874
- US-A-42 685 69
- ENGINEERS' DIGEST, vol. 38, no. 8, August 1977, pages 51-55, London, GB; W. SCHEDLER: "Coated hardmetals in the machine shop"
- PATENTS ABSTRACTS OF JAPAN, vol. 1, no. 53, 23rd May 1977, page 279 C 77; & JP - A - 52 10870 (SUMITOMO DENKI KOGYO K.K.) 27-01-1977
- VDI-Berichte 333, "Verschleiss-Schutz durch Oberflächenschichten", Tagung Stuttgart 1979, VDI-Verlag GmbH
- R.F. Bunshah et al., " Deposition Technologies for Films and Coatings", Noyes Publications, 1982

## Description

This invention relates to coated cemented carbides and more particularly with coated cemented carbides which have a hard coating so as to provide a tough surface of improved resistance to wear. Such carbides are intended particularly though not exlusively for use as cutting tools.

It has hitherto been proposed to coat cemented carbides with single layers or multilayers of titanium carbide, titanium carbonitride, titanium nitride, aluminium oxide (A1₂0₃) and the like by means of chemical vapour deposition. One example is given by Japanese Patent Publication No. 24982/1976. It has also been proposed to coat cemented carbides with single layers or multilayers of titanium carbide, titanium carbonitride, titanium nitride and such like by physical vapour deposition as described in. for example, Japanese Patent Publication No. 18474/1984.

In such coated cemented carbides, the substrate, usually constituted by carbide-titanium carbide-cobalt, is coated with a material which is harder but more brittle than the cemented carbide and accordingly the general toughness of the material is lowered and, when it is used to constitute a cutting tool, the cutting edge tends to break when the load stress on the cutting edge fluctuates. It is furthermore known that toughness is lowered to a greater extent when there is a larger bonding strength between the substrate and the film coating.

When cemented carbides are coated by chemical vapour deposition, in general there is a greater lowering of toughness owing to the elevated coating temperature (ordinarily about 1000°C) which produces a reaction between the substrate and the film coating or a coarsening of the grain size of the film itself. Cemented carbides coated by physical vapour deposition experience a lesser reduction in the toughness than carbides coated by chemical vapour deposition because the temperature at which the coating is performed is substantially lower, for example between 200 and 700°C. The lower temperature inhibits the reaction between the substrate and the coating and the coating film tends to be less grainy. For these reasons cemented carbides coated by physical vapour deposition have been preferred against those made by chemical vapour deposition for use in, for example, milling tools having interrupted cutting edges.

Cemented carbides coated with only titanium nitride, particularly when made by physical vapour deposition. are inferior in flankwear because titanium nitride has a lower hardness than titanium carbide. A cemented carbide coated with only titanium carbide has excellent flank wear but is inferior in respect of crater depth because it has a lower resistance to chemical reaction. Accordingly, many efforts have been made to improve cemented carbides. particularly by means of coating with titanium carbonitride, which has properties intermediate those of titanium carbide and titanium nitride ; these two materials have also been employed as laminated layers or otherwise in multilayerform. If a multilayer coating is used, it is preferable to employ a titanium nitride layer as the outermost layer so as to exploit its excellent resistance to chemical reaction and to employ a titanium carbide layer. exhibiting good flank wear, inside the titanium nitride layer. If a titanium carbonitride layer is employed, it is preferable to provide a layer of it between a titanium carbide layer and a titanium nitride layer, the latter layer being the outermost Such a structure is intended to enhance the effect of titanium nitride as the outermost layer.

However, when a titanium carbide layer is contiguous with a cemented carbide substrate, there is a tendency for diffusion between carbide (particularly tungsten carbide) contained in the substrate and the layer of titanium carbide even when the coating is produced by physical vapour deposition. This diffusion increases the bonding strength but reduces the toughness of the material and makes a tool constituted by the material liable to an increased rate of breakage particularly when the tool is used in conditions of fluctuating loads.

It is accordingly the object of the present invention to provide novel coated cemented carbides and particularly such carbides which exhibit excellent wear resistance. both in terms of flank wear and crater depth. and exhibit excellent toughness. It is a further object of the present invention to provide a cemented carbide alloy coated with a multilayer of titanium carbide, titanium nitride and titanium carbonitride by means of physical vapour deposition.

The present invention is based on an appreciation that a very thin titanium nitride layer applied by physical vapour deposition as the innermost layer in a multilayer coating of a cemented carbide lowers the bonding strength of the multilayer with the substrate and increases the toughness of the material generally, thereby improving the material for use as a cutting tool.

United States Patent No. 3640689 proposes the provision by means of chemical vapour deposition of a titanium nitride layer between a cemented carbide alloy and a layer of titanium carbide.

GB-A-1601224 discloses a sintered hard metal body containing a carbide (also known as a cemented carbide) and having a multilayer surface coating with an innermost layer of titanium nitride followed by a layer of titanium carbide and an outer layer of titanium nitride or titanium carbonitride. These layers are preferably applied by chemical vapour deposition with the first, innermost layer having a thickness in the range 1 to 6 f..lm and preferably 2 to 4 microns.

JP-A-605883 again disloses a coated cemented carbide with a multilayer surface coating with an innermost layeroftitanium nitride followed by a layer oftitan ium carbide and an outerlayeroftitanium nitride. These layers are applied by chemical vapour deposition. The first innermost layer is described as thin, from 0.10 to 3.0 µm thick, and the next, titanium carbide layer is described as thick, from 6.0 to 12.0 µm thick.

US-A-4268569 discloses a cemented carbide coated by sputtering or ion implantation with a layer or hafnium carbonitride having beneath it a double interlayer comprising a first layer of TiN approximately 0.5 to 1 µm in thickness and a second layer of TiC overlying said firstlayerof TiN and having thickness of approximately 0.5 to 1 µm.

The present invention provides a coated cemented carbide comprising a substrate of a cemented carbide having a multilayer surface coating consisting of an innermost layer of titanium nitride, a further layer of titanium carbide or titanium carbonitride and an outermost layer of titanium nitride, characterised in that the surface coating is formed by physical vapour deposition and has three layers of which the innermost layer has a thickness in the range 0.1 to 1wm, said further layer in contqact with the innermost layer has a thickness in the range 0.5 to 5 µm, and the outermost layer of titanium nitride has a thickness in the range 0.3 to 5 µm.

The invention also provides a coated cemented carbide comprising a substrate of a cemented carbide having a multilayer surface coating with an innermost layer of titanium nitride, at least one further layer of titanium carbide or titanium carbonitride and an outermost layer of titanium nitride, characterised in that the surface coating is formed by physical vapour deposition and is in four layer coating of which the innermost layer has a thickness in the range 0.1 to 1 µm, said further layer in contact with the innermost layer is titanium carbide with a thickness in the range 0.5 to 5 µm, there is an additional said further layer of titanium carbonitride as a third layer having a thickness 1 to 1.5 µm and the outermost layer of titanium nitride has a thickness in the range 0.3 to 5wm.

The invention further includes the method of coating a cemented carbide as described above by physical vapour deposition.

In the present invention, the first, innermost, layer of titanium nitride is provided not primarily for the purpose of utilising the wear resistance of titanium nitride but for the purpose of controlling the bonding strength between the substrate and the multilayer coating. Accordingly the innermost layer of titanium nitride should be of a thickness sufficient to reduce the bonding strength but not so thick as to provide significant reduction in the flank wear.

The thickness of the second layer, which is titanium carbide or titanium carbonitride, adjacent the innermost layer of titanium nitride is such as to improve the flank wear but not to produce brittleness.

If titanium carbide is employed as the second layer and titanium carbonitride as a third layer, the titanium carbonitride layer can be between 1 and 1.5 µm in thickness. The outermost layer of titanium nitride has a thickness greater than 0.3 µm. If it is significantly less than 0.3 µm, there is no improvement in resistance to cratering. If it is more than 5 µm, the wear resistance is decreased.

The total thickness of the coating is preferably in the range 1 to 10 µm. If it is less than 1 µm there is no improvement in wear resistance and if it is more than 10 µm the tool made from the material is rather brittle.

The multilayer is coated employing physical vapour deposition. Such deposition may be performed by means of ion plating, sputtering or vacuum vapour deposition employing sources of evaporation, electron beams, hollow cathode guns or arc discharges. Such particular methods may be used alone or in combination with other methods of performing physical vapour deposition.

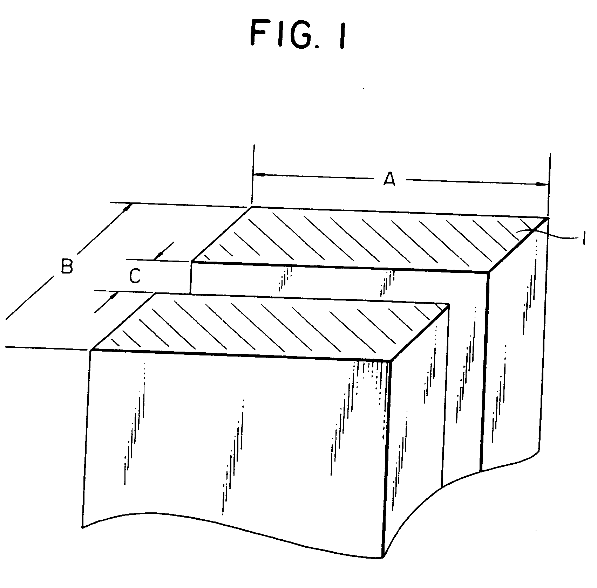

The accompanying drawing (Figure 1) is a perspective view of a workpiece used in a heavy milling test of the present invention.

The following Examples are given in order to illustrate the present invention in detail without intending to limit the scope of the invention.

### Example 1

A cemented carbide alloy (ISO P30) was machined into a throwaway insert with a form of SPG 422 and subjected to coating by ion plating to prepare various coated cemented carbides recited in Table 1. Identification and measurement of the film thicknesses were carried out by polishing the cross-section of the coating and observing by EPMA and an optical microscope. The resultant coated cemented carbides were subjected to a milling wear resistance test and toughness test by heavy milling (employing of diameter of 125 mm) as shown in Figure 1 under the conditions shown in Table 2. the results being set out in Table 1. In Figure 1, the workpiece has a dimension A of 150 mm. a dimension B of 100 mm and a cut groove C of 10 mm, the reference numeral 1 denoting the surface of the workpiece.

It is evident from Figure 1 that Samples 1 to 3 provide the best wear resistance and toughness in terms of breakage ratio as well as good cratering resistance.

In Table 1, Samples 4 to 15 are provided for comparison only and are not intended to illustrate the claimed invention.

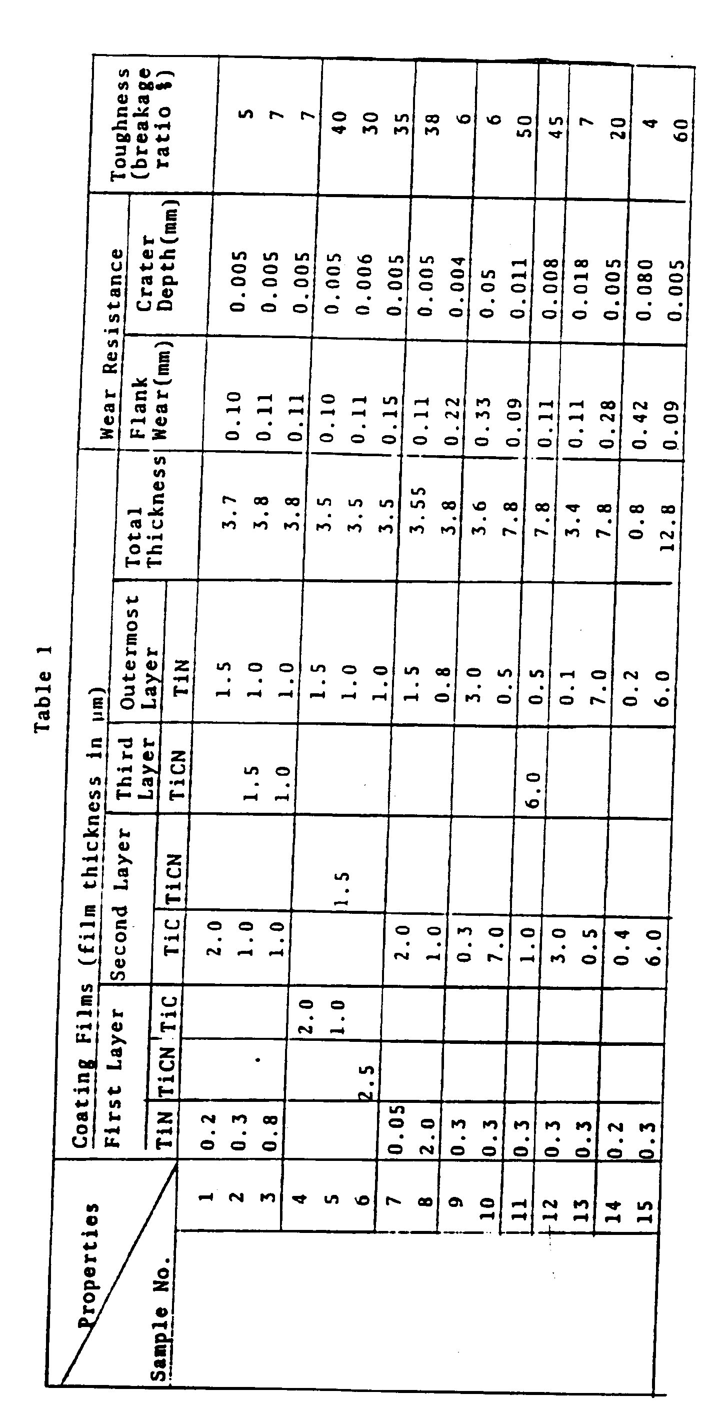

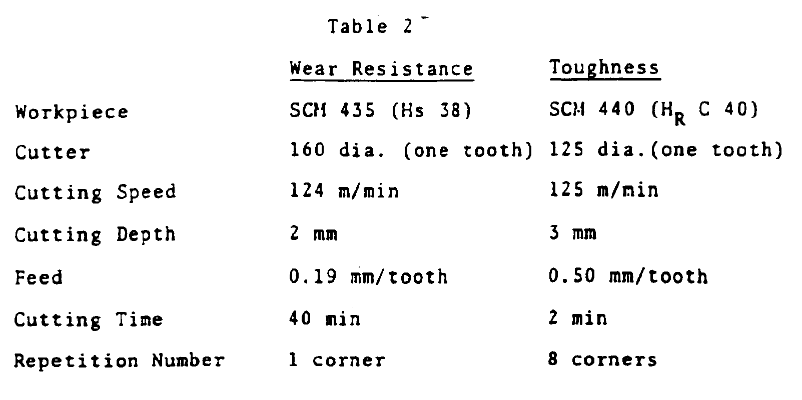

### Example 2

Coated cemented carbides shown in Table 3 were prepared in an analogous manner to Example 1 and then subjected to tests of wear resistance and toughness in an analogous manner and conditions to Example 1, thus obtaining results shown in Table 3. It is apparent from the results of this example that Sample Nos. 21 to 25 give best results in wear resistance and toughness. Sample 25 is an example of the invention.

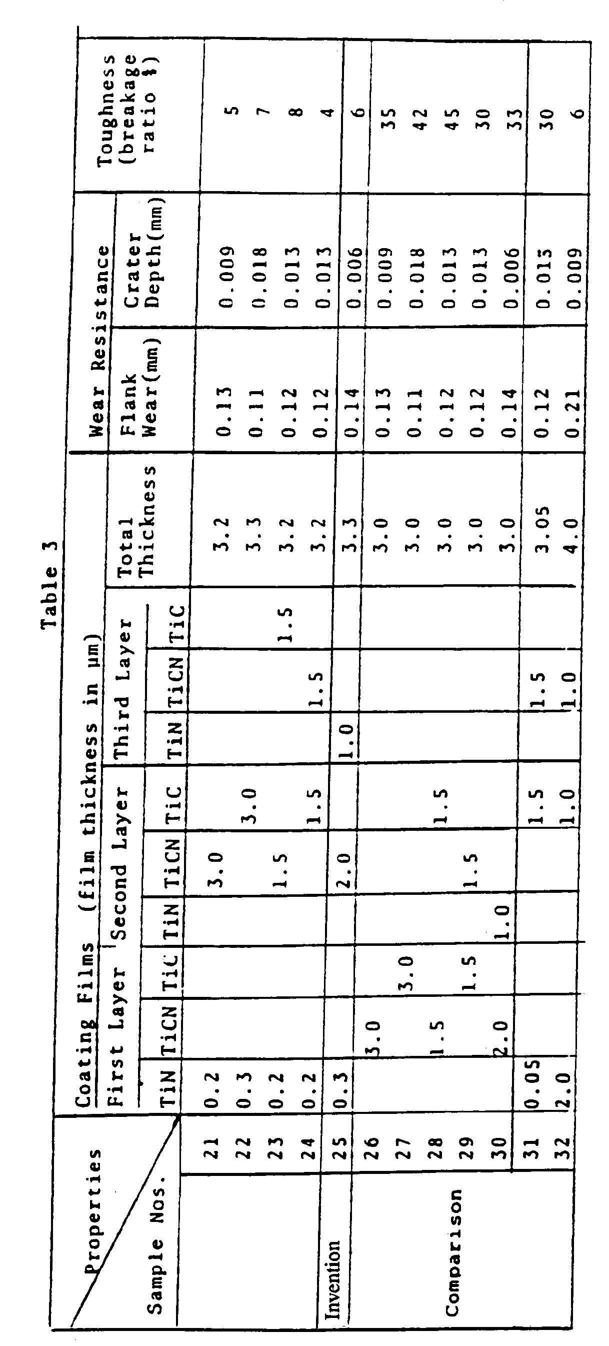

## Claims

1. A coated cemented carbide comprising a substrate of a cemented carbide having a multilayer surface coating consisting of an innermost layer of titanium nitride, a further layer of titanium carbide or titanium carbonitride and an outermost layer of titanium nitride, characterised in that the surface coating is formed by physical vapour deposition and has three layers of which the innermost layer has a thickness in the range 0.1 to 1µm, said further layer in contact with the innermost layer has a thickness in the range 0.5 to 5µm, and the outermost layer of titanium nitride has a thickness in the range 0.3 to 5µm.

2. A coated cemented carbide comprising a substrate of a cemented carbide having a multilayer surface coating with an innermost layer of titanium nitride, at least one further layer of titanium carbide or titanium carbonitride and an outermost layer of titanium nitride, characterised in that the surface coating is formed by physical vapour deposition and is a four layer coating of which the innermost layer has a thickness in the range 0.1 to 1 µm, said further layer in contact with the innermost layer is titanium carbide with a thickness in the range 0.5 to 5 µm, there is an additional said further layer of titanium carbonitride as a third layer having a thickness 1 to 1.5 µm and the outermost layer of titanium nitride has a thickness in the range 0.3 to 5µm.

3. A coated cemented carbide according to claim 1 or claim 2 wherein the innermost layer has a thickness 0.1 to 0.8 µm.

4. A coated cemented carbide according to claim 3 wherein the innermost layer has a thickness in the range 0.2 to 0.3 µm.

5. A coated cemented carbide according to any of claim 1 or claims 3 or 4 dependent on claim 1, wherein the multilayer coating is a three layer coating of which said further layer is a titanium carbide layer.

6. A coated cemented carbide according to claim 1 or claims 3 or 4 dependent on claim 1, wherein the multilayer coating is a three layer coating of which said further layer is titanium carbonitride.

7. A coated cemented carbide according to any preceding claim wherein the total thickness of the multilayer coating is between 1 and 10 µm.

8. The method of coating a cemented carbide as claimed in any preceding claim by physical vapour deposition.

## Patentansprüche

1. Beschichtetes Sinterkarbid, welches eine Grundlage aus einem Sintercarbid mit einer mehrschichtigen Oberflächenbeschichtung umfaßt, die aus einer innersten Schicht aus Titannitrid, einer weiteren Schicht aus Titancarbid oder Titancarbonitrid und einer äußersten Schicht aus Titannitrid besteht, dadurch gekennzeichnet, daß die Oberflächenbeschichtung durch physikalisches Aufdampfen hergestellt wird und drei Lagen hat, von denen die innerste Schicht eine Dicke im Bereich von 0,1 bis 1 µm, die weitere Schicht im Kontakt mit der innersten Schicht eine Dicke im Bereich von 0,5 bis 5 µm und die äußerste Schicht aus Titannitrid eine Dicke im Bereich von 0,3 bis 5 µm hat.

2. Beschichtetes Sintercarbid, welches eine Grundlage aus einem Sintercarbid mit einer mehrschichtigen Oberflächenbeschichtung umfaßt, die aus einer innersten Schicht aus Titannitrid, mindestens einer weiteren Schicht aus Titancarbid oder Titancarbonitrid und einer äußersten Schicht aus Titannitrid besteht, dadurch gekennzeichnet, daß die Oberflächenbeschichtung durch physikalisches Aufdampfen hergestellt wird und eine Beschichtung aus vier Lagen darstellt, von denen die innerste Schicht eine Dicke im Bereich von 0,1 bis 1 µm hat, die weitere Schicht im Kontakt mit der innersten Schicht aus Titancarbid mit einer Dicke im Bereich von 0,5 bis 5 µm besteht, darüber hinaus eine zusätzliche weitere Schicht aus Titancarbonitrid als dritte Schicht mit einer Dicke von 1 bis 1,5 µm vorhanden ist und die äußerste Schicht aus Titannitrid eine Dicke im Bereich von 0,3 bis 5 µm hat.

3. Beschichtetes Sintercarbid gemäß Anspruch 1 oder 2, bei dem die innerste Schicht eine Dicke von 0,1 bis 0,8 µm hat.

4. Beschichtetes Sintercarbid gemäß Anspruch 3, bei dem die innerste Schicht eine Dicke im Bereich von 0,2 bis 0,3 µm hat.

5. Beschichtetes Sintercarbid gemäß Anspruch 1 oder gemäß einem der von Anspruch 1 abhängigen Ansprüche 3 oder4, bei dem die mehrschichtige Beschichtung aus drei Lagen besteht, von denen die weitere Beschichtung eine Schicht aus Titancarbid ist.

6. Beschichtetes Sintercarbid gemäß Anspruch 1 oder gemäß einem der Ansprüche 3 oder 4, bei dem die mehrschichtige Beschichtung aus drei Lagen besteht, von denen die weitere Beschichtung Titancarbonitrid ist.

7. Beschichtetes Sintercarbid gemäß einem der vorstehenden Ansprüche, bei dem die Gesamtdicke der mehrschichtigen Beschichtung zwischen 1 und 10 µm beträgt.

8. Verfahren zur Beschichtung eines Sintercarbids, gemäß einem der vorstehenden Ansprüche, durch physikalisches Aufdampfen.

## Revendications

1. Carbure de cémentation revêtu, comprenant un substrat composé d'un carbure de cémentation ayant un revêtement de surface multicouche constitué d'une couche interne extrême de nitrure de titane, d'une couche autre de carbure ou de carbonitrure de titane et d'une couche externe extrême de nitrure de titane, caractérisé en ce que ledit revêtement de surface est formé par dépôt physique en phase vapeur et a trois couches dont la couche interne extrême présente une épaisseur dans l'intervalle 0.1 à 1 f..lm, ladite couche autre en contact avec la couche interne extrême présente une épaisseur dans l'intervalle 0.5 à 5 µm, et la couche externe extrême de nitrure de titane présente une épaisseur dans l'intervalle 0.3 à 5 µm.

2. Carbure de cémentation revêtu, comprenant un substrat composé d'un carbure de cémentation ayant un revêtement de surface multicouche constitué d'une couche interne extrême de nitrure de titane, d'au moins une couche autre de carbure ou de carbonitrure de titane et d'une couche externe extrême de nitrure de titane, caractérisé en ce que le revêtement de surface est formé par dépôt physique en phase vapeur et constitue un revêtement à quatre couches dont la couche interne extrême présente une épaisseur dans l'intervalle 0.1 à 1 µm, ladite couche autre en contact avec la couche interne extrême est constituée de carbure de titane avec une épaisseur dans l'intervalle 0.5 à 5 µm, et en ce qu'il y a une couche autre supplémentaire de carbonitrure de titane constituant une troisième couche et ayant une épaisseur d'1 à 1.5 µm et la couche externe extrême de nitrure de titane présente une épaisseur dans l'intervalle 0.3 à 5 µm.

3. Carbure de cémentation revêtu selon la revendication 1 ou 2, dans lequel la couche interne extrême présente une épaisseur de 0.1 à 0.8 µm.

4. Carbure de cémentation revêtu selon la revendication 3, caractérisé en ce que la couche interne extrême présente une épaisseur dans l'intervalle 0.2 à 0.3 µm.

5. Carbure de cémentation revêtu selon la revendication 1 ou la revendication 3 ou 4 subordonnée à la revendication 1, dans lequel le revêtement multicouche est un revêtement à trois couches dont ladite couche autre est une couche de carbure de titane.

6. Carbure de cémentation revêtu selon la revendication 1 ou la revendication 3 ou 4 subordonnée à la revendication 1, caractérisé en ce que le revêtement multicouche est un revêtement à trois couches dont ladite couche autre est du carbonitrure de titane.

7. Carbure de cémentation revêtu selon l'une quelconque des revendications précédentes, dans lequel l'épaisseur totale du revêtement multicouche se situe entre 1 et 10 µm.

8. Procédé pour revêtir un carbure de cémentation selon l'une quelconque des revendications précédentes par dépôt physique en phase vapeur.
